Europäisches Patentamt

European Patent Office

Office européen des brevets

(11) Publication number: **0 226 293 B1**

# EUROPEAN PATENT SPECIFICATION

(45) Date of publication of patent specification: **22.04.92**

(51) Int. Cl.⁵: **H01L 21/60**, H01L 23/48, H01L 27/02

(21) Application number: **86307941.4**

(22) Date of filing: **14.10.86**

(54) **Method for producing a buried contact Schottky logic array, and device produced thereby.**

(30) Priority: **16.10.85 US 787865**

(43) Date of publication of application:
**24.06.87 Bulletin  87/26**

(45) Publication of the grant of the patent:
**22.04.92 Bulletin  92/17**

(84) Designated Contracting States:
**DE FR GB**

(56) References cited:
**JP-A-60 074 466**
**US-A- 4 214 256**

**IBM TECHNICAL DISCLOSURE BULLETIN, vol. 21, no. 3, August 1978, pages 1050-1051, New York, US; L. CARPENTER et al.: "Schottky transistor logic cell"**

(73) Proprietor: **TEXAS INSTRUMENTS INCORPO-RATED**
**13500 North Central Expressway**
**Dallas Texas 75265(US)**

(72) Inventor: **Morris, Francis J.**
**1036 Sunswept Terrace**
**Plano, Texas(US)**
Inventor: **Evans, Stephen A.**
**6815 Carolyncrest**
**Dallas, Texas(US)**

(74) Representative: **Abbott, David John et al**
**Abel & Imray Northumberland House 303-306 High Holborn**
**London, WC1V 7LH(GB)**

## Description

### TECHNICAL FIELD OF THE INVENTION

The present invention pertains to the fabrication of integrated circuits and more particularly pertains to the fabrication of passivated logic arrays having Schottky diodes.

### BACKGROUND OF THE INVENTION

A conventional approach to the fabrication of integrated Schottky transistor logic arrays is to fabricate a "master slice" logic array, including all active devices. Thereafter, the surface of the master slice is passivated by a passivation layer and stored pending programming of the slice. The slice is custom-programmed by selectively opening vias to particular devices.

When emitter areas and other critical components are scaled down to one micrometer size, there is a problem in finding them under the passivation layer. Chances are therefore increased that a misalignment between the emitter via and the emitter contact surface will occur, in turn increasing the chance that a less-than-ideal connection will be made. It has therefore been unfeasible to passivate highly miniaturized master slices and store them for future, custom programmation steps. Instead, logic arrays having extremely small controlling dimensions must be custom programmed immediately without an intervening passivation step. If a passivating layer such as nitride or oxide is not deposited on the slice surface, non-programmed semiconductor devices present on the chip must be circumvented by the leads. This decreases routing channel flexibility.

Another problem associated with fabrication, passivation and later custom programming of Schottky transistor logic arrays is inadequate passivation of the Schottky diodes. The Schottky diodes are generally formed by depositing a layer of metal next to a lightly doped area of semiconductor material. The type of metal deposited on the semiconductor material determines the height of the Schottky diode barrier. Platinum Silicide (PtSi) has a higher Schottky diode characteristic than aluminum, a typical contact metal. Where a high-barrier Schottky diode is desired to be fabricated, it is therefore important to prevent low barrier metal from circumventing the high-barrier metal Schottky contact pad. If established, a low barrier Schottky diode will dominate the operating characteristics of the diode junction.

In a conventional process, a first, high-barrier metal such as platinum, iridium or palladium is deposited in the Schottky diode contact. Where platinum is used, platinum silicide (PtSi) forms on contact. A premetal cleanup dip is then done before the deposition of the second metal. This dip can etch the oxide surrounding the first metal pad, exposing the underlying semiconductor. When a second metal such as aluminum or titanium/tungsten composite (Ti-W) is used as a lead to the device, filling the diode contact, the second metal may contact the semiconductor where the oxide has been etched.

Aluminum and Ti-W have lower barrier diode characteristics than PtSi. Any contact between them and the semiconductor will create a low-barrier diode that dominates or "shorts out" the high barrier PtSi diode. The risk of high barrier Schottky diode shortout decreases quality control of the finished slice.

Another problem associated with the decreasing size of integrated circuit emitters is emitter-collector short-out. In order to provide an ohmic contact with each active region of a semiconductor device, a contact region of highly doped material is provided. However, for proper formation of the space charge region, the emitter also needs to retain a less heavily doped, active region. As the entire emitter is scaled down in size, problems arise in separating the different dopant concentrations found in the emitter and emitter contact regions, so that the highly doped emitter contact region may spike through the base to the collector region. Since high concentrations of dopant increase conductivity, the emitter-collector junction is shorted out.

In view of the above problems, a need has arisen to develop a process for fabricating a Schottky transistor logic array having small dimensional size but enhanced quality control. A further need exists to provide a process whereby a Schottky transistor logic array may be stored in a passivated state pending custom programmation.

In US-A-4 214 256 there is described a method of fabricating a Schottky barrier diode in which after forming a layer of platinum silicide on a silicon substrate through a first window in a coating of silicon nitride and silicon oxide on the substrate, successive layers of polyether sulphone, an organic polymer, a methyl-silicone resin and a radiation sensitive resist are applied over the whole surface. Selective exposure to radiation followed by development is used to form a mask defining a second window overlying and larger than the first window. The layers exposed through the mask are then removed to form the second window in which the platinum silicide and a surrounding ring of silicon nitride and silicon oxide are exposed. Successive layers of tantalum, chrome and aluminium, or copper-doped aluminium or aluminium-silicon, are then applied to form a connection to the platinum silicide after which the layers of polyether sulphone, organic polymer, methyl-siloxane resin and radiation sensitive resist are dissolved away so that the metal layers can be removed where they do not overlie the platinum silicide (the so-called lift-off technique).

It is an object of the present invention to provide an improved Schottky diode and a method of making it.

According to one aspect of the present invention there is provided a method of forming a Schottky diode on semiconductor layer of a wafer comprising:

forming a first layer on the first area of the semiconductor layer, the first layer comprising a metal or a metallic compound;

covering the first layer with a dielectric layer;

exposing a second area on the first layer by forming an orifice through the dielectric layer, the second area (90) being entirely within the first area; and

forming a conductive body in the orifice, the conductive body extending from the metal layer to the exterior in order to provide a buried Schottky diode between the semiconductor layer and the metal layer.

According to a second aspect of the present invention there is provided a buried Schottky diode, comprising:

a semiconductor layer;

a first insulating layer formed on said semiconductor layer;

an orifice formed in said first insulating layer to expose a first area on the semiconductor layer;

a metal layer formed on said first area, said metal layer having a perimeter;

a second insulating layer formed on said first insulating layer and in said orifice ;

a via formed in said second insulating layer to said metal layer, said via exposing a second area on said metal layer inwardly spaced from said perimeter; and

a conductive layer extending into said via to contact said second area.

## BRIEF DESCRIPTION OF THE DRAWINGS

For a more complete understanding of the present invention and the advantages thereof, reference is now made to the following description taken in conjunction with the accompanying Drawings in which:

FIGURES 1-9 are schematic elevational sections of a substrate, depicting progressive steps in the fabrication process of the invention;

FIGURE 10 is a sectional detail of FIGURE 9, showing the structure of the buried Schottky diode of the invention;

FIGURE 11 is a schematic electrical diagram of the device fabricated in the steps shown in FIGURES 1-10; and

FIGURES 12-14 are schematic elevational sections of a substrate in the same general fabricating field as the substrate depicted in FIGURES 1-8, showing progressive steps in a process for fabricating a ROM diode.

## DETAILED DESCRIPTION OF THE INVENTION

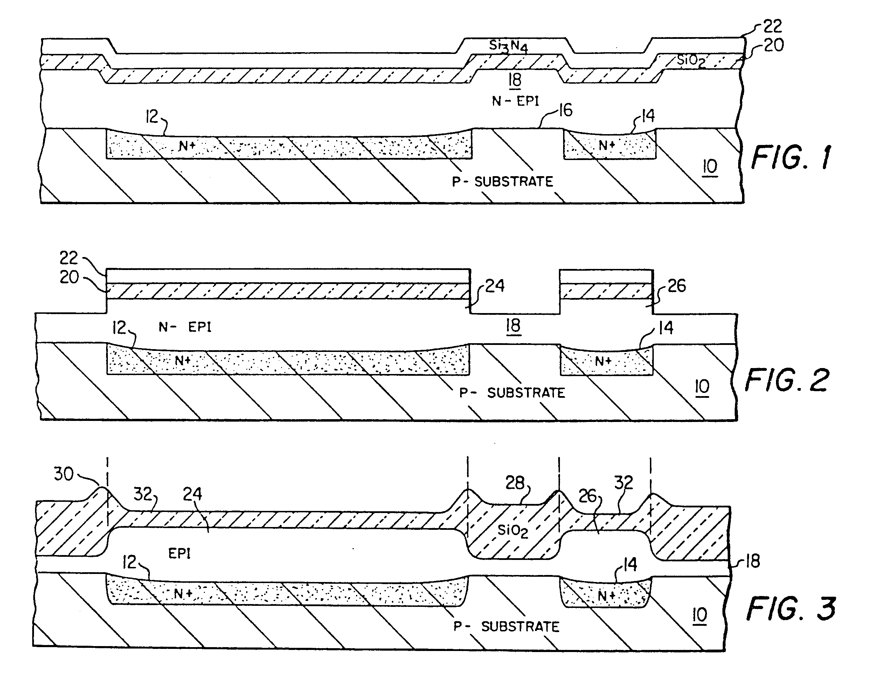

Referring to FIGURE 1, there is shown a lightly doped P- type substrate 10 which is manufactured through conventional processes. The P- substrate will preferably have a resistivity of 10 to 15 Ohms/square. A 0.25 to 0.5$\mu$m (2500 to 500Å) layer of silicon dioxide (hereinafter, "oxide") (not shown) is grown, and the oxide is patterned for a buried collector region 12 and a resistor tank region 14. 0.25$\mu$m (2500Å) of oxide are plasma etched in the patterned areas, and an N-type dopant such as antimony is implanted into collector 12 and resistor tank region 14. The structure is then annealed at 1250°C. for 25 minutes under an oxygen atmosphere. This anneal step activates the antimony to turn areas 12 and 14 into N+ doped regions. During the antimony anneal, heavily doped regions 12 and 14 oxidize faster than the lighter doped substrate regions 10, and therefore shallow depressions are left in regions 12 and 14.

The oxide is then wet stripped and 0.05$\mu$m (500Å) of substrate 10 is vapor etched with hydrogen chloride in order to provide a clean surface 16. One micrometer (10,000 Angstroms) of an 0.3 Ohm/square N- epitaxial silicon layer 18 is then grown on surface 16. Layer 18 will include depressions which generally correspond to the shallow depressions formed in regions 12 and 14. Next, an oxide layer 20, typically between 0.06 and 0.11$\mu$m (600 and 1100Å) thick, is grown by a steam treatment at 900°C. A nitride (Si$_3$N$_4$) layer 22 is deposited on top of oxide layer 20 by a low-pressure chemical vapor deposition (LPCVD) process.

By this point in the conventional process, an implantation of P+ channel stops would already have been done. These channel stops are normally implanted between N+ areas 12 and 14 in order to prevent the formation of parasitic metal oxide semiconductor field effect transistors. According to the present invention, these P+ channel stops are implanted during a later step.

Turning now to FIGURE 2, epitaxial layer 18 is patterned in order to preserve semiconductor device regions 24 and 26 over substrate areas 12 and 14, respectively. A plasma etch is then done, cutting through about 0.11$\mu$m(1100Å) of nitride layer 22, about 0.11$\mu$m (1100Å) of oxide layer 20 and about 0.385$\mu$m(3850Å) of epitaxial layer 18. This etch defines and separates raised active-device epitaxial regions 24 and 26.

Referring to FIGURE 3, an oxide layer 28 about $0.7\mu m(7000\text{Å})$ thick is grown in all areas not covered by remaining nitride layer 22 (oxide does not grow on a nitride layer). A thicker oxide layer 28 could be grown down to substrate 10 in order to completely oxide-isolate device regions 24 and 26. Nitride layer 22 masks the device regions 24 and 26 from thick field oxide layer 28. Nitride layer 22 is thereafter removed and oxide layer 20 is wet stripped from active device regions 24 and 26. Oxide layer 20 is removed because, as shown by bird's beaks 30, it has been greatly stressed in the earlier process steps and needs to be replaced for proper quality control. Therefore, an oxide layer 32 about $0.06\mu m(600\text{Å})$ thick is regrown over active device regions 24 and 26.

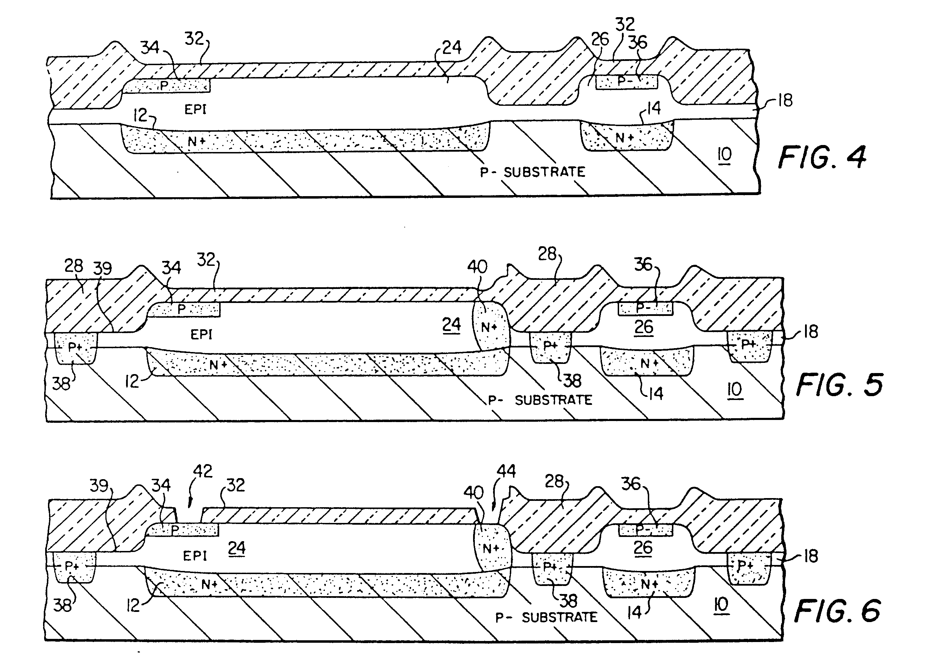

Referring to FIGURE 4, a P base region 34 is patterned with a thick photoresist implant mask (not shown) and boron is implanted through oxide layer 32. The P base photoresist mask is then removed. Next, a P resistor 36 is patterned with another thick photoresist and boron is implanted here also. Two different patterns and implantations are used because P resistor 36 is doped with a smaller concentration of boron than P base region 34. The photoresist mask is then stripped. Base region 34 is patterned such that it occupies only a segment of active device region 24. The energy of the implanted boron dopant is such that P base region 34 is spaced from collector region 12 and P resistor region 36 is spaced from resistor tank region 14.

Turning now to FIGURE 5, the next step in the preferred sequence is to pattern P+ channel stops 38.

The channel stop formation process is done at this point rather than earlier to obtain better control of surface concentrations at an oxide-epitaxial surface 39 and therefore better control of the threshold voltage for the device. This sequencing of the channel stop formation also prevents the lateral diffusion of boron, as would occur if the channel stop implants had been done before the growth of epitaxial silicon layer 18 (FIGURE 1). This lateral diffusion occurs in the prior art process because the epitaxial process requires a very high temperature. A resist mask sufficient to mask a high energy implant is used, as boron is implanted at high energy through oxide pad areas 28 in this step. The P+ channel stop photoresist mask is thereafter removed. Next, $0.3\mu m$ (3000Å) of plasma oxide (not shown) are deposited to act as a mask for a deep N+ collector contact 40. This $0.3\mu m$ (3000Å) oxide layer of oxide is patterned, and then $0.36\mu m$ (3600Å) of oxide is plasma etched, changing the profile of oxide layer 32 above collector contact 40 as shown. Collector contact 40 is doped

through a $POCl_3$ diffusion for 25 minutes at 950°C. under an oxygen and nitrogen atmosphere. Collector contact 40 is formed so as to provide a conductive path to deep collector region 12 and so as to be spaced from P base region 34. This step also activates the boron implants in P+ channel stop regions 38, base region 34 and resistor 36.

Referring to FIGURE 6, orifices 42 and 44 are next patterned and plasma etched down to P base region 34 and collector contact region 40. Approximately $0.36\mu m$ (3600Å) of oxide 32 is removed.

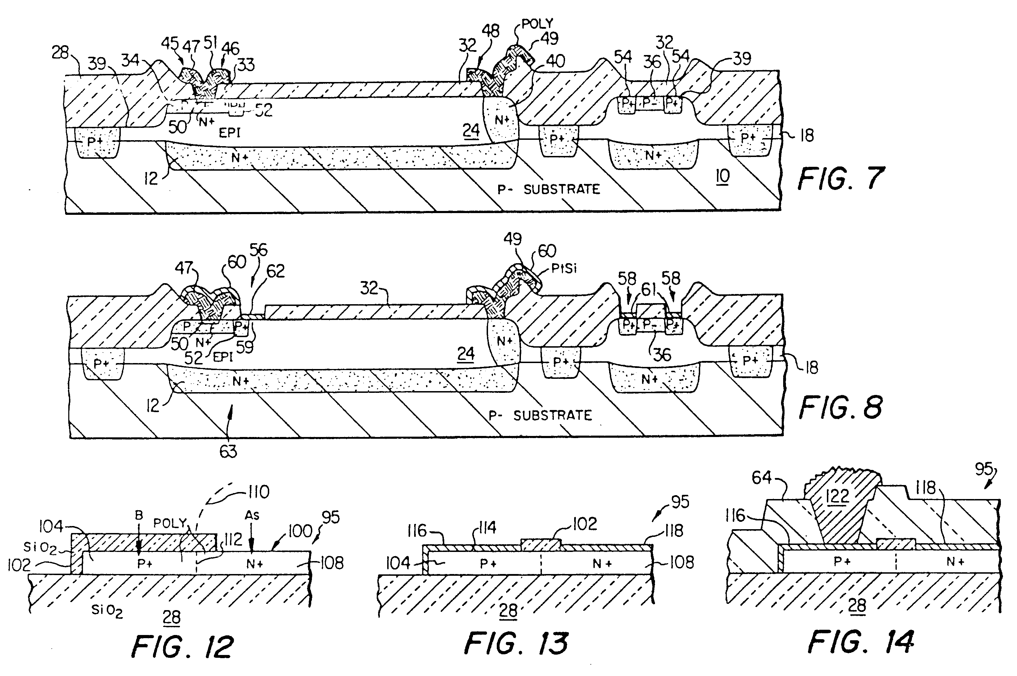

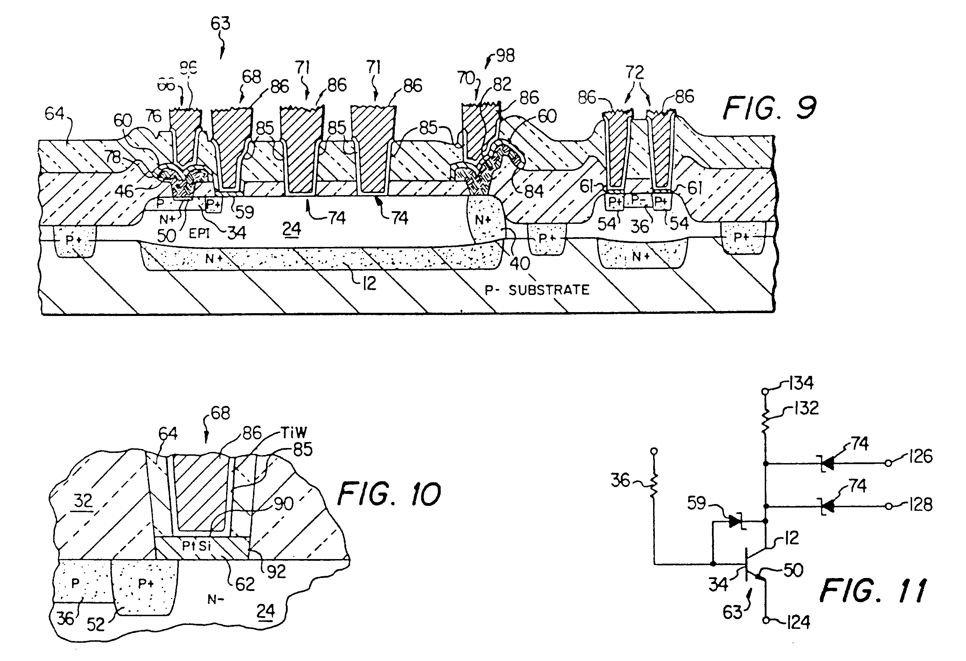

In FIGURE 7, a layer 45 of polycrystalline silicon (or "poly" as it is known in the art) about $0.2\mu m$ (2000Å) thick is deposited by low-pressure chemical vapor deposition (LPCVD). Emitter and collector poly terminals 46 and 48 are then patterned and heavily implanted with arsenic to make them N-type. Layer 45 is then plasma etched to define terminals 46 and 48 and annealed at 1000°C. for 20 to 30 minutes under a nitrogen atmosphere. The poly layer 45 may be implanted with arsenic and annealed before it is patterned. The anneal diffuses the arsenic out of the polysilicon bodies 46 and 48 into P base region 34 and collector contact region 40, respectively. Arsenic diffusion into collector contact region 40 improves the Ohmic contact between region 40 and poly terminal 48. The arsenic diffusion from poly terminal 46 into P base region 34 creates an N-type emitter region 50.

Poly emitter terminal 46 and emitter region 50 comprise the emitter of the transistor, although the space charge region of the emitter is restricted to N+ emitter region 50. Poly emitter terminal 46 provides good Ohmic contact with emitter region 50 from the exterior. Poly terminals 46 and 48 present larger surface areas 47 and 49 to the exterior than N+ emitter region 50 and N+ collector contact region 40, respectively. During custom metallization after the master slice has been completed and passivated, the large areas 47 and 49 provide bigger targets to "hit" through the passivation layer (later described), reducing misalignment problems during metallization.

To further enhance process tolerance, poly terminals 46 and 48 can be laterally extended over oxide layer 28 to inactive areas of the wafer. The corresponding leads 86 (see FIGURE 9) would then be aligned to make contact with poly terminals 46 and 48 in these inactive areas. If a problem such as spike-through of the poly or misalignment occurs, the device in region 24 will be unaffected.

Next, the P+ regions are patterned, including a base P+ region 52 and resistor P+ regions 54. Boron is used to implant these P+ regions through oxide layer 32. Base P+ region 52 and resistor P+ region 54 are formed adjacent to epitaxial oxide surface 39. Base P+ region 52 provides a conductive contact point for base 34. It is spaced from collector 12, emitter region 50 and is in this embodiment far removed from collector contact region 40. Resistor P+ regions 54 provide good ohmic contacts to P resistor 36. After the boron is implanted into P+ regions 52 and 54, the photoresist is stripped and the structure is annealed at approximately 900°C under a nitrogen atmosphere. This low temperature anneal activates the boron implants.

Turning now to FIGURE 8, a Schottky/base orifice 56 and P+ resistor region vias 58 are next patterned. Orifice 56 is patterned so that a portion of oxide layer 32 is removed down to epitaxial layer 18 to expose both an area on base contact region 52 and an area on an unimplanted region 59 of active device region 24. After patterning, orifice 56 and vias 58 are plasma etched into oxide layer 32.

Next, platinum is deposited on the wafer, coating the silicon exposed in orifice 56, and resistor vias 58 and coating poly surfaces 47 and 49. The wafers are then heated to a temperature ranging between 450°C. and 525°C to form platinum silicide (PtSi) layers 60, 61 and 62 on polysilicon surfaces 47 and 49, and on exposed areas of regions 52, 54 and 59. PtSi layers 60 make a good Ohmic contact with the heavily doped polysilicon surfaces 47 and 49. Platinum silicide will not form on oxide layer 32, thereby assuring that a space will remain between PtSi layer 60 and PtSi layer 62 in orifice 56. Layer 32 is deep enough with respect to the thickness of layers 60 and 62 to prevent contact between layers 60 and 62.

PtSi layer 62 provides a good ohmic contact to base P+ region 52 and at the same time creates a Schottky diode to N- epitaxial region 59. This Schottky diode will clamp the base during operation of the transistor so that the transistor does not go heavily into saturation. PtSi layers 61 form a good ohmic contact with P+ resistor regions 54. Layers 60-62 may alternately be formed of palladium or iridium silicide.

With the exception of the low-barrier Schottky logic diodes (later described), the logic array has at this stage been completed. The logic array includes a plurality of Schottky transistors 63 and a like plurality of resistors 36. Resistor 36 and its P+ regions 54 have been fabricated in only one step additional to the process of fabricating Schottky transistor 63 alone: implanting P- resistor region 36.

In FIGURE 9, the last steps of the basic process of the invention are illustrated. A layer 64 of oxide, about 0.6μm(6000Å) thick, is deposited over the entire structure for passivation, i.e., for preventing contamination of the device. Deposited oxide layer 64 could be replaced with a dual layer of undoped and doped deposited oxide, a dual layer of oxide and nitride, or a tri-layer of undoped oxide, doped oxide and nitride.

After passivating and insulating layer 64 has been deposited, the master slice can be stored until it is metallized per the customer's requirements. To custom program a ROM, vias are opened through layer 64 on a selective basis to devices 36 and 63 underneath. Layer 64 thus allows additional lead routing flexibility over devices which are not used in a particular custom process. Layer 64 is thick enough to prevent any parasitic effects such as stray capacitance.

FIGURE 9 illustrates how vias or orifices 66-72 are opened to access the active regions of the device. These vias are fabricated by patterning and plasma etching insulating layer 64. In the case of the poly emitter terminal 46, a via 66 is patterned such that it will expose an area 76 on PtSi layer 60 well spaced from a layer perimeter 78. This prevents the spike-through of metal through a partially etched peripheral area of oxide layer 32 to epitaxial region 24 by a subsequently deposited metal lead. Similarly, a via 70 to metal contact layer 60 of collector terminal 48 is patterned such that it will form an area 82 on metal contact 60 which is well spaced from a perimeter 84 of the metal contact 60.

Two vias 71 are shown that make contact to lightly doped regions at points in active device tank 24 removed from base region 34, P+ region 52 and collector contact region 40. These regions will form low-barrier Schottky logic diodes 74 once metal is deposited in vias 71. Although only two logic diodes 74 are shown for simplicity, up to between five and eight logic diodes can be fabricated. The horizontal extent of active device tank 24 and collector 12 are increased with each additional logic diode 74. Two vias 72 are opened up to access PtSi resistor contacts 61.

The method of making base/Schottky via 68 is better shown in FIGURE 10. Via 68 is formed in insulating and passivating layer 64 such that its dimensions will be smaller than earlier orifice 56 (FIGURE 8). Therefore, via 68 defines an area 90 on Schottky/base PtSi contact layer 62 which is spaced from a contact layer perimeter 92. The sizing of via 68 therefore "buries" PtSi contact 62 such that a lower barrier diode metal such as an aluminum lead 86 or a Ti-W layer 85 (partially shown) cannot circumvent contact 62 when it is deposited in via 68. As previously discussed, any contact made between N- epitaxial layer 24 and a low barrier metal will tend to short out the high-barrier diode formed by PtSi contact 62 and region 24.

After the vias 66-72 have been formed in layer 64, a layer of titanium/tungsten composite (Ti-W) is deposited over the wafer, making contact to transistor 63, resistor 36 and logic diodes 74 through vias 66-72. The deposition of Ti-W is followed by another layer of first level metal, typically composed of 98% A1-2% Cu. The Ti-W and A1-Cu layers are then patterned and etched using conventional plasma processes to leave Ti-W layers 85 and A1-Cu leads 86 extending into vias 66-72. The contact of Ti-W layers 85 in vias 71 with N-type epitaxial material forms a plurality of low-barrier Schottky logic diodes 74. Low barrier diodes 74 (only two shown, although there are more typically five per transistor) are used to perform the logic functions in Schottky Transistor Logic (STL). The remainder of the metallization levels are completed using conventional multilevel processes.

FIGURE 11 depicts the Schottky logic array device fabricated according to FIGURES 1-10. Like parts are numbered with like numerals. A transistor 63 has a base 34, a collector 12 and an emitter 50. Emitter 50 is connected to emitter terminal 124. A high-barrier PtSi Schottky diode 59 is connected between base 34 and collector 12, and prevents transistor 63 from going into heavy saturation. A plurality of low-barrier Ti-W Schottky logic diodes 74 (two shown) are connected between collector 12 and logic terminals 126 and 128. A resistor 36 is connected between base 34 and a base terminal 130, and a resistor 132 is connected between collector 12 and a collector terminal 134.

FIGURES 12-14 depict a modification of the basic process depicted in FIGURES 1-10, whereby an on-chip polysilicon ROM diode 95 can be fabricated during the process. Referring to FIGURE 12, a polycrystalline silicon layer 100 is deposited on another region of thick field oxide layer 28 at the same time that polysilicon layer 45 (FIGURE 7) is deposited. Next, an oxide layer 102 is deposited to cover a future anode 104 of ROM diode 95. Layer 102 is patterned to mask anode 104 from a subsequent anode/emitter implant. At the time that arsenic is implanted in polysilicon bodies 46 and 48, arsenic is also implanted in a cathode region 108 of ROM diode 95, to make the cathode N type. Cathode region 108 is adjacent anode region 104.

Next, a photoresist mask 110 (shown in phantom) is placed to cover anode 108. A boron implantation is then made through insulating layer 102 in order to make anode 104 P type.

In one embodiment, the boron implant into anode 104 is combined with the boron implant into P+ contact regions 52-54 (FIGURE 7). The boron implant energy is adjusted such that it penetrates oxide layer 32 but is insufficient to penetrate both a portion 51 of polysilicon emitter 46 and a portion 33 of oxide layer 32 underneath poly emitter portion 51. This self-aligned process eliminates an otherwise necessary masking and implant step.

Returning to FIGURE 12, ROM diode 95 is annealed at the same time and under the same conditions that polysilicon bodies 46 and 48 are annealed. This diffuses arsenic ions from cathode 108 underneath insulating layer 102 into anode 104, establishing a PN junction 112 in an area covered by oxide layer 102. In an alternate embodiment, the aforementioned single-step boron implant into regions 52, 54 and 104 can be done after this anneal, which would reduce the diffusion of dopant from P+ base region 52 (FIGURE 7) into epitaxial region 24. This would lower capacitance and increase the collector-base breakdown characteristic of Schottky transistor 63.

Referring to FIGURE 13, oxide layer 102 is masked to expose a contact surface 114 of anode 104, and a corresponding portion of oxide layer 102 is removed. Then, PtSi (or other metal silicide) layers 116 and 118 are deposited on anode surface 114 and cathode 108 at the same time that PtSi or other metal silicide layers are deposited on polysilicon bodies 46 and 48 and in base/Schottky orifice 56 (FIGURE 8).

In FIGURE 14, the finished ROM diode 95 is covered with insulating and passivating layer 64 together with Schottky transistor 63. The master slice, which includes a plurality of ROM diodes 95 and a plurality of Schottky transistors 63 (FIGURE 9) may then be stored pending custom metallization. When it is desired to program the master slice, a ROM diode via 122 is opened to PtSi layer 116 in the case that a "1" bit is to be returned, and a metal such as Ti-W or aluminum is deposited in the via. The metal deposited in via 122 can operate as a bit line, in which case PtSi layer 118 operates as a word line.

In summary, a logic array process is disclosed which can be used for small (~1μm) emitter sizes and therefore compact integrated circuits in general, and which at the same time allows the storage of master slices in a passivated state. In particular, a method is disclosed for fabricating poly emitters, poly collector contact terminals and buried Schottky diodes which allow pre-metallization storage. Although the process of the invention has been disclosed as fabricating a Schottky transistor logic (STL) array including a Schottky transistor, a resistor, logic diodes and a ROM diode all on the same wafer, the invention may be used to fabricate other components of integrated circuits.

## Claims

1. A method of forming a buried Schottky diode on a semiconductor layer of a wafer comprising:

   forming a first layer (62) on the first area of the semiconductor layer (24), the first layer (62) comprising a metal or a metallic compound;

covering the first layer (62) with a dielectric layer (64);

exposing a second area (90) on the first layer (62) by forming an orifice (68) through the dielectric layer (64), the second area (90) being entirely within the first area; and

forming a conductive body (86) in the orifice (68), the conductive body (86) extending from the metal layer (62) to the exterior in order to provide a buried Schottky diode between the semiconductor layer (24) and the first layer (62).

2. A method according to claim 1, characterised in that the first layer (62) is formed of a silicide having a metallic component of platinum, palladium or iridium.

3. A method according to claim 1 or 2, characterised in that the semiconductor layer (24) forms the collector of a transistor.

4. A method according to any of claims 1, 2 and 3, characterised by the further steps of:

forming an insulating layer (32) on the semiconductor layer (24) prior to forming the first layer (62);

opening a second orifice (56) through the insulating layer (32) to expose the first area; and

forming the first layer (62) in the second orifice (56) on the first area.

5. A method according to claim 4, characterised in that the exposed first area includes a transistor contact region surface and a lightly doped region surface, the first layer (62) providing a contact to the contact region surface.

6. A method according to claim 5, characterised in that a resistor is fabricated simultaneously on the same wafer as the transistor and the Schottky diode, the method including the further steps of

doping a resistor region (36) in a second semiconductor layer (26) laterally adjacent to the semiconductor layer (24), the insulating layer (32) covering both semiconductor layers, the resistor region (36) adjacent to the insulating layer (32) and having a plurality of ends;

heavily doping a plurality of second resistor regions (54), a second resistor region (54) being adjacent to each end of the resistor region (36), the second resistor regions (54) being adjacent to the insulating layer (32) and laterally spaced from the collector (12), the second resistor regions (54) being doped during a step of doping the transistor contact region;

opening a resistor contact orifice (58) through the insulating layer to each second resistor contact region (54) during the step of forming the second orifice (56);

forming resistor contact conductive layers (61) on each second resistor region (54) during the step of forming the first layers (62); and

forming conductive resistor leads (86) in the resistor contact orifices during the step of forming the conductive body.

7. A method according to claim 6, characterised in that a plurality of transistors, Schottky diodes and resistors are formed on the wafer, the method including the further steps of:

covering the orifice (52) and the resistor contact orifices (58) with the dielectric layer (64) after forming the first layer (62) and forming the resistor contact conductive layers (61);

storing the wafer in a passivated and unprogrammed condition;

thereafter programming the unprogrammed wafer by selectively opening vias (68,72) to the first layer (62) and resistor contact layers (61), the conductive body and conductive resistor leads (86) being formed in the vias (68,72).

8. A method according to claim 7, characterised by further including the steps of:

opening a plurality of logic diode vias (71) in the dielectric layer (64) during the step of programming the wafer, opening vias in the logic diode vias (71) exposing portions of the semiconductor layer (24) removed from the first layer (62); and

forming logic diode conductive leads (86) in the logic diode vias (71) during the step of forming the conductive resistor leads and the conductive body, the logic diode conductive leads (86) contacting the semiconductor layer (24) to form low-barrier Schottky logic diodes.

9. A method according to claim 8, characterised in that the step of forming the conductive leads and the conductive body comprises:

depositing a layer of titanium-tungsten composite in the vias; and

depositing an alloy comprising aluminium over the layer of titanium-tungsten composite.

10. A buried Schottky diode, comprising:

a semiconductor layer (24);

a first insulating layer (32) formed on said semiconductor layer (24);

an orifice (56) formed in said first insulating layer (32) to expose a first area on the semiconductor layer (24);

a metal layer (62) formed on said first area, said metal layer (62) having a perimeter (92);

a second insulating layer (64) formed on said first insulating layer (32) and in said orifice (56);

a via (68) formed in said second insulating layer (64) to said metal layer (62), said via (68) exposing a second area (90) on said metal layer (62) inwardly spaced from said perimeter (92); and

a conductive layer (85) extending into said via (68) to contact said second area (90).

11. A Schottky diode according to claim 10 characterised in that said first area includes exposed surfaces of a heavily doped region (52) and a relatively lightly doped region (59), said metal layer (62) and said lightly doped region (59) forming the Schottky diode.

12. A Schottky diode according to claim 11 characterised in that said heavily doped region (52) is connected to a transistor.

13. A Schottky diode according to claim 12 characterised in that said heavily doped region (52) is a base contact region of the transistor.

14. A Schottky diode according to claim 10 characterised by further comprising:

a resistor region (26) having a plurality of ends formed in said semiconductor layer (24) laterally spaced from said Schottky diode;

a plurality of resistor contact regions (54) formed on said resistor region ends adjacent the surface of said semiconductor layer (24);

said first insulating layer (32) covering said resistor contact regions (54), a resistor contact orifice (58) being opened in said first insulating layer (32) to each resistor contact region (54), a resistor contact metal layer (61) formed in each resistor contact orifice (58);

a resistor lead (86) extending into each resistor contact orifice (56) to connect a respective resistor contact metal layer (61) to the exterior.

15. A Schottky diode according to claim 10 characterised by further including:

a plurality of logic diode vias (71) opened in said first (32) and second (64) insulating layers to said semiconductor layer (24), said logic diode vias (71) spaced from said metal layer (62);

a metallic lead (86) formed in each logic diode via (71) to form a logic diode (74) with said semiconductor layer (24).

16. A Schottky diode according to claim 14 or claim 15 characterised in that said conductive layer (85) and said metallic leads (86) are formed of a plurality of heterogeneous layers.

17. A Schottky diode according to claim 16 characterised in that said heterogeneous layers include a first layer (85) comprising titanium-tungsten composite (Ti-W) deposited in said orifices before a second layer (86) comprising aluminum or aluminum-copper alloy.

**Revendications**

1. Procédé pour former une diode à barrière de Schottky enterrée sur une couche semi-conductrice d'une pastille comprenant :

- la formation d'une première couche (62) sur la première zone de la couche semi-conductrice, la première couche (62) comprenant un métal ou un composé métallique;

- la couverture de la première couche (62) par une couche diélectrique (64) ;

- l'exposition d'une seconde zone (90) sur la première couche (62) en formant un orifice (68) à travers la couche diélectrique (64), la seconde zone (90) étant entièrement comprise à l'intérieur de la première zone ; et

- la formation d'un corps conducteur (86) dans l'orifice (68), le corps conducteur s'étendant de la couche métallique (62) à l'extérieur de manière à fournir une diode à barrière de Schottky enterrée entre la couche semi-conductrice (24) et la première couche (62).

2. Procédé selon la revendication 1, caractérisé en ce que la première couche (62) est formée d'un siliciure comportant un composé métallique de platine, palladium ou iridium.

3. Procédé selon la revendication 1 ou 2, caractérisé en ce que la couche semi-conductrice (24) constitue le collecteur d'un transistor.

4. Procédé selon l'une quelconque des revendications 1, 2 et 3 caractérisé par les étapes supplémentaires suivantes :

- formation d'une couche isolante (32) sur la couche semi-conductrice (24) avant la formation de la première couche (62) ;

- ouverture d'un second orifice (56) à travers la couche isolante (32) pour exposer la première zone ; et
- formation de la première couche (62) dans le second orifice (56) sur la première zone.

5. Procédé selon la revendication 4, caractérisé en ce que la première zone exposée comprend une surface de zone de contact de transistor et une surface de zone faiblement dopée, la première couche (62) fournissant un contact avec la surface de zone de contact.

6. Procédé selon la revendication 5, caractérisé en ce que l'on forme simultanément une résistance sur la même pastille que le transistor et la diode à barrière de Schottky, le procédé comprenant les étapes supplémentaires suivantes:

   - dopage d'une zone de résistance (36) dans une seconde couche semi-conductrice (26) latéralement adjacente à la couche semi-conductrice (24), la couche isolante (32) couvrant les deux couches semi-conductrices, la zone de résistance (36) adjacente à la couche isolante (32) et comportant une pluralité d'extrémités;
   - dopage à forte concentration d'une pluralité de secondes zones de résistance (54), une seconde zone de résistance (54) étant adjacente à chaque extrémité de la zone de résistance (36), les secondes zones de résistance (54) étant adjacentes à la couche isolante (32) et séparées latéralement du collecteur (12), les secondes zones de résistance (54) étant dopées pendant une étape de dopage de la zone de contact de transistor ;
   - ouverture d'un orifice (58) de contact de résistance à travers la couche isolante vers chaque seconde zone (54) de contact de résistance pendant l'étape de formation du second orifice (56) ;
   - formation de couches (61) conductrices de contact de résistance sur chaque seconde zone de résistance (54) pendant l'étape de formation des premières couches (62) ; et
   - formation de bornes conductrices de résistance (86) dans les orifices de contact de résistance pendant l'étape de formation du corps conducteur.

7. Procédé selon la revendication 6, caractérisé en ce qu'une pluralité de transistors, de diodes à barrière des Schottky et de résistances sont formés sur la pastille, le procédé comprenant les étapes supplémentaires suivantes :

   - couverture de l'orifice (52) et des orifices (58) de contact de résistance avec la couche diélectrique (64) après formation de la première couche (62) et formation de couches (61) conductrices de contact de résistance ;
   - stockage de la pastille dans un état passivé et non programmé ;
   - programmation ensuite de la pastille non programmée par l'ouverture sélective d'interconnexions (68,72) vers la première couche (62) et les couches (61) de contact de résistance, le corps conducteur et les bornes de résistance (86) étant formés dans les interconnexions (68,72).

8. Procédé selon la revendication 7, caractérisé en outre par les étapes suivantes :

   - ouverture d'une pluralité d'interconnexions de diode logique (71) dans la couche diélectrique pendant l'étape de programmation de la pastille, ouverture d'interconnexions dans les interconnexions (71) de diode logique en exposant des parties de la couche semi-conductrice (24) retirées de la première couche (62); et
   - formation de bornes (86) de diode logique dans les interconnexions (71) de diode logique pendant l'étape de formation des bornes conductrices de résistance et du corps conducteur, les bornes conductrices (86) de diode logique venant en contact avec la couche semi-conductrice (24) pour former des diodes logiques de Schottky à faible barrière.

9. Procédé selon la revendication 8, caractérisé en ce que l'étape de formation des bornes conductrices et du corps conducteur comprend :

   - le dépôt d'une couche composite à base de titane-tungstène dans les interconnexions ; et
   - le dépôt d'un alliage comprenant de l'aluminium sur la couche de composite à base de titane-tungstène.

10. Diode à barrière de Schottky enterrée comprenant :

   - une couche semi-conductrice (24) ;
   - une première couche isolante (32) formée sur ladite couche semi-conductrice (24) ;
   - un orifice (56) formé dans ladite première couche isolante (32) pour exposer une première zone sur la couche semi-conductrice (24) ;

- une couche métallique (62) formée sur ladite première zone, ladite couche métallique (62) présentant un périmètre (92) ;
- une seconde couche isolante (64) formée sur ladite première couche isolante (32) et dans ledit orifice (56) ;
- une interconnexion (68) formée dans ladite seconde couche isolante (64) vers ladite couche métallique (62), ladite interconnexion (68) exposant une seconde zone (90) sur ladite couche métallique (62) à l'intérieur et à distance dudit périmètre (92) ; et
- une couche conductrice (85) s'étendant dans ladite interconnexion (68) pour venir en contact avec ladite seconde zone (90).

11. Diode à barrière de Schottky selon la revendication 10, caractérisée en ce que ladite première zone comprend des surfaces exposées d'une zone (52) fortement dopée et d'une zone (59) relativement faiblement dopée, ladite couche métallique (62) et ladite zone (59) faiblement dopée formant la diode à barrière de Schottky.

12. Diode à barrière de Schottky selon la revendication 11, caractérisée en ce que ladite zone (52) fortement dopée est reliée à un transistor.

13. Diode à barrière de Schottky selon la revendication 12, caractérisée en ce que ladite zone (52) fortement dopée est une zone de contact de base du transistor.

14. Diode à barrière de Schottky selon la revendication 10, caractérisée en ce qu'elle comprend en outre:

- une zone (26) de résistance comportant une pluralité d'extrémités formées dans ladite couche semi-conductrice (24) latéralement espacée de ladite diode à barrière de Schottky ;
- une pluralité de zones (54) de contact de résistance formées sur lesdites extrémités de zones de résistance adjacentes à la surface de ladite couche semi-conductrice (24) ;
- ladite première couche isolante (32) couvrant lesdites zones (54) de contact de résistance, un orifice (58) de contact de résistance étant ouvert dans ladite première zone isolante (32) vers chaque zone (54) de contact de résistance, une couche (61) métallique de contact de résistance formée dans chaque orifice (58) de contact de résistante ;

- une borne (86) de résistance s'étendant dans chaque orifice (56) de contact de résistance pour relier une couche métallique (61) de contact de résistance respective à l'extérieur.

15. Diode à barrière de Schottky selon la revendication 10, caractérisée en ce qu'elle comprend en outre:

- une pluralité d'interconnexions de diode logique (71) ouvertes dans lesdites première (32) et seconde (64) couches isolantes vers ladite couche semi-conductrice (24), lesdites interconnexions (71) de diode logique étant espacées de ladite couche métallique (62);
- une borne métallique (86) formée dans chaque interconnexion (71) de diode logique pour former une diode logique (74) avec ladite couche semi-conductrice (24).

16. Diode à barrière de Schottky selon la revendication 14 ou 15, caractérisée en ce que ladite couche conductrice (85) et lesdits conducteurs métalliques (86) sont formés d'une pluralité de couches hétérogènes.

17. Diode à barrière de Schottky selon la revendication 16, caractérisée en ce que lesdites couches hétérogènes comportent une première couche (85) comprenant un composite à base de titane-tungstène (Ti-W) déposé dans lesdits orifices avant une seconde couche (86) comprenant un alliage d'aluminium ou d'aluminium-cuivre.

**Patentansprüche**

1. Verfahren zur Bildung einer vergrabenen Schottky-Diode auf einer Halbleiterschicht einer Scheibe, enthaltend:

Erzeugen einer ersten Schicht (62) auf der ersten Fläche der Halbleiterschicht (24), wobei die erste Schicht (62) aus einem Metall oder einer Metallverbindung besteht;

Bedecken der ersten Schicht (62) mit einer dielektrischen Schicht (64);

Freilegen einer zweiten Fläche (90) auf der ersten Schicht (62) durch Bilden einer Öffnung (68) durch die dielektrische Schicht (64), wobei die zweite Fläche (90) vollständig innerhalb der ersten Fläche liegt; und

Erzeugen eines leitenden Körpers (86) in der Öffnung (68), wobei sich der leitende Körper (68) von der Metallschicht (62) nach außen erstreckt, damit zwischen der Halbleiterschicht (24) und der ersten Schicht (62) eine vergrabene Schottky-Diode besteht.

2. Verfahren nach Anspruch 1, dadurch gekennzeichnet, daß die erste Schicht (62) aus einem Silicid mit einer metallischen Komponente aus Platin, Palladium oder Iridium gebildet ist.

3. Verfahren nach Anspruch 1 oder 2, dadurch gekennzeichnet, daß die Halbleiterschicht (24) den Kollektor eines Transistors bildet.

4. Verfahren nach einem der Ansprüche 1, 2 und 3, gekennzeichnet durch die weiteren Schritte:

Erzeugen einer isolierenden Schicht (32) auf der Halbleiterschicht (24) vor der Bildung der ersten Schicht (62);

Öffnen einer zweiten Öffnung (56) durch die isolierende Schicht (32) zur Freilegung der ersten Fläche; und

Erzeugen der ersten Schicht (62) in der zweiten Öffnung (56) auf der ersten Fläche.

5. Verfahren nach Anspruch 4, dadurch gekennzeichnet, daß die freigelegte erste Fläche die Oberfläche einer Transistorkontaktzone und die Oberfläche einer schwach dotierten Zone umfaßt, wobei die erste Schicht (62) einen Kontakt mit der Kontaktzonenoberfläche bildet.

6. Verfahren nach Anspruch 5, dadurch gekennzeichnet, daß gleichzeitig mit dem Transistor und der Schottky-Diode auf der gleichen Scheibe ein Widerstand hergestellt wird, wobei das Verfahren folgende weitere Schritte enthält:

Dotieren einer Widerstandszone (36) in einer zweiten Halbleiterschicht (26) seitlich angrenzend an die Halbleiterschicht (24), wobei die isolierende Schicht (32) beide Halbleiterschichten bedeckt und wobei die Widerstandszone (36) an die isolierende Schicht (32) angrenzt und mehrere Enden aufweist;

starkes Dotieren mehrerer zweiter Widerstandszonen (54), wobei eine zweite Widerstandszone (54) angrenzend an jedes Ende der Widerstandszone (36) liegt, die zweiten Widerstandszonen (54) angrenzend an die isolierende Schicht (32) und seitlich im Abstand von dem Kollektor (12) liegen und während des Schritts des Dotierens der Transistorkontaktzone dotiert werden;

Öffnen einer Widerstandskontaktöffnung (58) durch die isolierende Schicht zu jeder zweiten Widerstandskontaktzone (54) während des Schritts des Erzeugens der zweiten Öffnung (56);

Bilden von leitenden Widerstandskontaktschichten (61) an jeder zweiten Widerstandszone (54) während der Bildung der ersten Schichten (62); und

Bilden leitender Widerstandsleitungen (86) in Widerstandskontaktöffnungen während der Bildung des leitenden Körpers.

7. Verfahren nach Anspruch 6, dadurch gekennzeichnet, daß in der Scheibe mehrere Transistoren, Schottky-Dioden und Widerstände gebildet werden, wobei das Verfahren folgende weitere Schritte enthält:

Bedecken der Öffnung (52) und der Widerstandskontaktöffnungen (58) mit einer dielektrischen Schicht (64) nach der Bildung der ersten Schicht (62) und der Bildung der leitenden Widerstandskontaktschichten (61);

Speichern der Scheibe in einem passivierten und nicht programmierten Zustand;

Programmieren der nicht programmierten Scheibe durch selektives Öffnen von Durchgängen (68, 72) zu der ersten Schicht (62) und den Widerstandskontaktschichten (61), wobei der leitende Körper und die leitenden Widerstandsleitungen (86) in den Durchgängen (68, 72) gebildet werden.

8. Verfahren nach Anspruch 7, gekennzeichnet durch folgende weitere Schritte:

Öffnen mehrerer Logikdioden-Durchgänge (71) in der dielektrischen Schicht (64) während des Schritts der Programmierung der Scheibe, Öffnen von Durchgängen in den Logikdioden-Durchgängen (71), die Abschnitte der Halbleiterschicht (24), die von der ersten Schicht (62) entfernt ist, freilegen; und

Erzeugen von leitenden Logikdioden-Leitungen (86) in den Logikdioden-Durchgängen (71) während des Schritts der Bildung der leitenden Widerstandsleitungen und des leitenden Körpers, wobei die leitenden Logikdioden-Leitungen (86) mit der Halbleiterschicht (24) in Kontakt stehen, damit Schottky-Logikdioden mit niedrigem Schwellenwert entstehen.

9. Verfahren nach Anspruch 8, dadurch gekennnzeichnet, daß der Schritt des Bildens der leitenden Leitungen und des leitenden Körpers folgendes umfaßt:

Ablagern einer Schicht aus einem Titan-Wolfram-Verbundmaterial in den Durchgängen; und

Ablagern einer Aluminium enthaltenden Legierung über der Schicht aus dem Titan-Wolfram-Verbundmaterial.

**10.** Vergrabene Schottky-Diode, enthaltend:

eine Halbleiterschicht (24);

eine erste isolierende Schicht (32) auf der Halbleiterschicht (24);

eine in der ersten isolierenden Schicht (32) gebildete Öffnung (56) zum Freilegen einer ersten Fläche auf der Halbleiterschicht (24);

eine Metallschicht (62) auf der ersten Fläche, wobei die Metallschicht (62) einen Umfangsrand (92) hat;

eine zweite isolierende Schicht (64) auf der ersten isolierenden Schicht (32) und in der Öffnung (56);

einen in der zweiten isolierenden Schicht (64) gebildeten Durchgang (68) zu der Metallschicht (62), wobei der Durchgang (68) eine zweite Fläche (90) auf der Metallschicht (62) nach innen im Abstand von dem Umfangsrand (92) freilegt; und

eine leitende Schicht (85), die sich durch den Durchgang (68) in Kontakt mit der zweiten Fläche (90) erstreckt.

**11.** Schottky-Diode nach Anspruch 10, dadurch gekennzeichnet, daß die erste Fläche freigelegte Oberflächen einer stark dotierten Zone (52) und eine relativ schwach dotierte Zone (59) enthält, wobei die Metallschicht (62) und die schwach dotierte Zone (59) die Schottky-Diode bilden.

**12.** Schottky-Diode nach Anspruch 11, dadurch gekennzeichnet, daß die stark dotierte Zone (52) an einen Transistor angeschlossen ist.

**13.** Schottky-Diode nach Anspruch 12, dadurch gekennzeichnet, daß die stark dotierte Zone (52) eine Basiskontaktzone des Transistors ist.

**14.** Schottky-Diode nach Anspruch 10, ferner enthaltend:

eine Widerstandszone (26) mit mehreren Enden in der zweiten Halbleiterschicht (24) seitlich im Abstand von der Schottky-Diode;

mehrere Widerstandskontaktzonen (54), die auf den Enden der Widerstandszone angrenzend an die Oberfläche der Halbleiterschicht (24) gebildet sind;

wobei die erste isolierende Schicht (32) die Widerstandskontaktzonen (54) bedeckt und eine Widerstandskontaktöffnung (58) in der ersten isolierenden Schicht (32) zu jeder Widerstandskontaktzone (54) geöffnet ist und eine Widerstandskontaktmetallschicht (61) in jeder Widerstandekontaktöffnung (58) gebildet ist;

eine Widerstandsleitung (86), die sich in jede Widerstandskontaktöffnung (56) erstreckt, um eine jeweilige Widerstandskontaktmetallschicht (61) mit dem Äußeren zu verbinden.

**15.** Schottky-Diode nach Anspruch 10, dadurch gekennzeichnet, daß sie ferner enthält:

mehrere Logikdioden-Durchgänge (71), die in der ersten (32) und der zweiten (64) isolierenden Schicht zu der Halbleiterschicht (24) gebildet sind, wobei die Logikdioden-Durchgänge (71) im Abstand von der Metallschicht (62) liegen;

eine Metalleitung (86), die in jedem Logikdiodendurchgang (71) gebildet ist, um eine Logikdiode (74) mit der Halbleiterschicht (24) zu bilden.

**16.** Schottky-Diode nach Anspruch 14 oder 15, dadurch gekennzeichnet, daß die leitende Schicht (85) und die Metalleitungen (86) aus mehreren heterogenen Schichten gebildet sind.

**17.** Schottky-Diode nach Anspruch 16, dadurch gekennzeichnet, daß die heterogenen Schichten eine erste Schicht (85) aus einem Titan-Wolfram-Verbundmaterial (Ti-W) enthalten, die in den Öffnungen vor einer zweiten Schicht (86) aus Aluminium oder einer Aluminium-Kupfer-Legierung aufgebracht ist.

**FIG. 1**

**FIG. 2**

**FIG. 3**

FIG. 4

FIG. 5

FIG. 6

EP 0 226 293 B1

FIG. 7

FIG. 8

FIG. 12

FIG. 13

FIG. 14

FIG. 9

FIG. 10

FIG. 11